(19) Europäisches Patentamt
European Patent Office
Office européen des brevets

(11) **EP 0 871 945 B1**

(12) **EUROPÄISCHE PATENTSCHRIFT**

(45) Veröffentlichungstag und Bekanntmachung des Hinweises auf die Patenterteilung:
**21.04.2004   Patentblatt 2004/17**

(21) Anmeldenummer: **96946049.2**

(22) Anmeldetag: **06.12.1996**

(51) Int Cl.$^7$: **G08B 13/24**

(86) Internationale Anmeldenummer:
**PCT/DE1996/002342**

(87) Internationale Veröffentlichungsnummer:
**WO 1997/021242 (12.06.1997 Gazette 1997/25)**

(54) **ANZEIGELEMENT FÜR DIE VERWENDUNG IN EINEM MAGNETISCHEN DIEBSTAHLSICHERUNGSSYSTEM**

DISPLAY ELEMENT FOR USE IN A MAGNETIC THEFT-PREVENTION SYSTEM

AFFICHEUR DESTINE A L'UTILISATION DANS UN SYSTEME DE SECURITE MAGNETIQUE CONTRE LE VOL

(84) Benannte Vertragsstaaten:
**BE DE DK ES FR GB IE IT SE**

(30) Priorität: **07.12.1995  DE 19545755**

(43) Veröffentlichungstag der Anmeldung:
**21.10.1998   Patentblatt 1998/43**

(73) Patentinhaber: **Vacuumschmelze GmbH**
**63450 Hanau (DE)**

(72) Erfinder: **HERZER, Giselher**
**D-63486 Bruchköbel (DE)**

(74) Vertreter: **Boff, James Charles et al**
**Phillips & Leigh**
**5 Pemberton Row**
**London EC4A 3BA (GB)**

(56) Entgegenhaltungen:
**WO-A-90/03652          US-A- 5 469 140**

**Beschreibung**

Die Erfindung betrifft ein Anzeigeelement für die Verwendung in einem magnetischen Diebstahlsicherungssystem bestehend aus einem länglichen, duktilen, magnetostriktiven, aus amorphem ferromagnetischen Material bestehenden Streifen, welcher durch Anlegen/Entfernen eines Vormagnetisierungsfeldes $H_K$ aktivierbar/deaktivierbar ist und welcher durch ein magnetisches Wechselfeld im aktivierten Zustand zu longitudinalen, mechanischen Resonanzschwingungen bei einer Resonanzfrequenz $f_r$ anregbar ist, wobei die aus den Resonanzschwingungen resultierenden mechanischen Spannungen eine Magnetisierungsänderung des Streifens und damit eine detektierbare Veränderung der Magnetisierung des Streifens bewirken.

Wenn man einen Streifen aus amorphem magnetostriktiven Material einem Magnetfeld aussetzt, so bedingt die Magnetostriktion eine Längenänderung des Streifens. Bei positiver Magentostriktion wird sich der Streifen mit zunehmendem Magnetfeld längen. Diese Abhängigkeit ist jedoch nicht linear, sondern abhängig von den Abmessungen des Streifens und von der Größe des Magnetfeldes. Erhöht man das Magnetfeld schrittweise um jeweils den gleichen Betrag bei einem bestimmten Streifen, so stellt man fest, daß zunächst nur kleine Längenänderungen erfolgen, daß die Längenänderungen mit zunehmenden Schritten für die Erhöhung der Magnetisierung größer werden und daß bei Eintritt der Sättigung trotz weiter schrittweise erhöhtem Magnetfeld keine weitere Längenänderung erfolgt.

Diese Eigenschaft bewirkt, daß sich ein derartiger Streifen vorzugsweise dann zu mechanischen Schwingungen anregen läßt, wenn er einem Vormagnetisierungsfeld ausgesetzt ist, dessen Größe eine hohe Längenänderung bei gleicher Änderung des Magnetfeldes zur Folge hat. Weiterhin bewirkt die durch das Magnetfeld erfolgende Längenänderung, daß sich in diesem Bereich die Länge des Streifens ändert, ohne daß eine Zugkraft auf den Streifen wirkt.

Bei der mechanischen Schwingung eines Streifens ist für die Resonanzfrequenz der Schwingung der Elastizitätsmodul des Materials maßgebend. Je größer dieser Elastizitätsmodul ist, um so größer ist eine für eine bestimmte Längenänderung erforderliche Kraft und um so höher wird die Resonanzfrequenz des schwingenden Streifens sein. Durch die Einwirkung des Magnetfeldes erfolgt nun aber eine zusätzliche Längenänderung, ohne daß eine Kraft notwendig ist. Das Material wirkt also so, als ob es einen geringeren als den mechanischen Elastizitätsmodul haben würde.

Dies hat zur Folge, daß mit zunehmender Vormagnetisierung bei Anregung mechanischer Schwingungen durch ein magnetisches Wechselfeld die Resonanzfrequenz niedriger wird, als sie ohne Vormagnetisierung des Streifens ist. Ein Streifen, der bei gegebener Vormagnetisierung bei einer bestimmten Resonanzfrequenz mit hoher Signalamplitude schwingt, wird bei Anregung mit gleicher Frequenz wesentlich weniger schwingen, wenn das Vormagnetisierungsfeld entfernt wird, da sich die Resonanzfrequenz dadurch erhöht und die anregende Frequenz und die Resonanzfrequenz nicht mehr übereinstimmen.

Außerdem bewirkt die Entfernung des Vormagnetisierungsfeldes, daß eine Änderung des Magnetfeldes nur noch eine relativ geringe Änderung der Länge des Streifens zur Folge hat, so daß ohne Vormagnetisierungsfeld auch die Signalhöhe wesentlich abnimmt.

Beide Faktoren zusammen haben zur Folge, daß bei Entfernung des Vormagnetisierungsfeldes ein mechanisches Schwingen des Streifens unterbunden wird. Es ist also möglich, einen Anzeigeelement aus diesem Material dadurch zu deaktivieren, daß man das Vormagnetisierungsfeld entfernt.

Dies wird bei Anzeigeelementen beispielsweise dadurch erreicht, daß man einen mit dem weichmagnetischen Streifen verbundenen halbhart magnetischen weiteren Streifen entmagnetisiert. Bei anderen Systemen, bei denen das Vormagnetisierungsfeld von einer Spule im Untersuchungsbereich miterzeugt wird, läßt sich die Schwingung unterbinden, in dem man dieses Vormagnetisierungsfeld abschaltet.

Aus der WO 90/03652 sind Legierungen mit hoher Magnetostriktion bekannt, die neben Eisen im wesentlichen Nickel enthalten, und für Anzeigeelemente der eingangs genannten Art vorgeschlagen werden. Die US-A-5 469 140 offenbart Legierungen mit hohen Kobaltgehalt.

Die dort vorgeschlagenen Legierungen weisen aber keine hohe Signalamplitude und kein langes Anhalten des Signals nach Abschalten des erregenden Feldes auf, ihre Resonanzfrequenz ist stark von der Vormagnetisierungsfeldstärke abhängig und ihre Deaktivierungsmöglichkeit ist eingeschränkt, so daß keine genügend große Änderung der Resonanzfrequenz beim Entfernen des Vormagnetisierungsfeldes erfolgt.

Aufgabe der vorliegenden Erfindung ist es daher, Anzeigeelemente der eingangs genannten Art dahingehend weiterzuentwickeln, daß eine hohe Signalamplitude und ein langes Anhalten des Signals nach Abschalten des erregenden Feldes vorliegt, eine geringe Abhängigkeit der Resonanzfrequenz von der vormagnetisierenden Feldstärke vorliegt, gleichzeitig eine sichere Deaktivierungsmöglichkeit des Streifens vorliegt, d.h. eine genügend große Änderung der Resonanzfrequenz beim Entfernen des vormagnetisierenden Feldes, sowie eine hinreichende Duktilität, so daß eine mechanische Beanspruchung ohne Beeinträchtigung der magnetischen Eigenschaften möglich ist.

Erfindungsgemäß wird diese Aufgabe durch die Merkmale des unabhängigen Anspruchs 1 gelöst.

Durch die Verwendung eines solchen Materials in einem Anzeigeelement können Fehlalarme vollständig vermieden werden, d.h. es wird eine sichere Deaktivierbarkeit der Anzeigeelemente gewährleistet.

Darüber hinaus zeigt die Verwendung eines solchen Materials weitere große Vorteile, die im folgenden eingehend beschrieben werden.

Vorteilhafte Weiterbildungen der Erfindung sind Gegenstand der Unteransprüche.

Die Erfindung ist in der Zeichnung beispielsweise veranschaulicht und im nachstehenden, im einzelnen anhand der Figuren beschrieben. Dabei zeigen:

Figur 1    die induzierte Spannung als Funktion der Frequenz des anregenden Wechselfeldes für einen 38 mm langen Streifen aus einem Material gemäß der vorliegenden Erfindung,

Figur 2    den typischen Verlauf der Einhüllenden der Resonanzamplitude bei Anregung mit Wechselfeldpulsen,

Figur 3    Resonanzfrequenz und Resonanzamplitude (0,1 ms und 2 ms nach Abschalten des anregenden Wechselfeldpulses) eines 38 mm langen und 6 mm breiten und 25 $\mu$m dicken Streifens als Funktion des Vormagnetisierungsfeldes $H_K$,

Figur 4    eine typische B-H-Schleife eines Materials nach dem Stand der Technik, wobei das Inset eine Vergrößerung des zentralen, nicht linearen Teils der Schleife zeigt,

Figur 5    eine typische lineare Hystereseschleife nach Wärmebehandlung im magnetischen Querfeld eines 38 mm langen und 6 mm breiten Streifens aus einem Material gemäß der vorliegenden Erfindung, wobei der Streifen das in Figur 3 gezeigte Resonanzverhalten aufweist und die gestrichelte Linie in der Figur 5 den theoretisch idealen Verlauf zeigt,

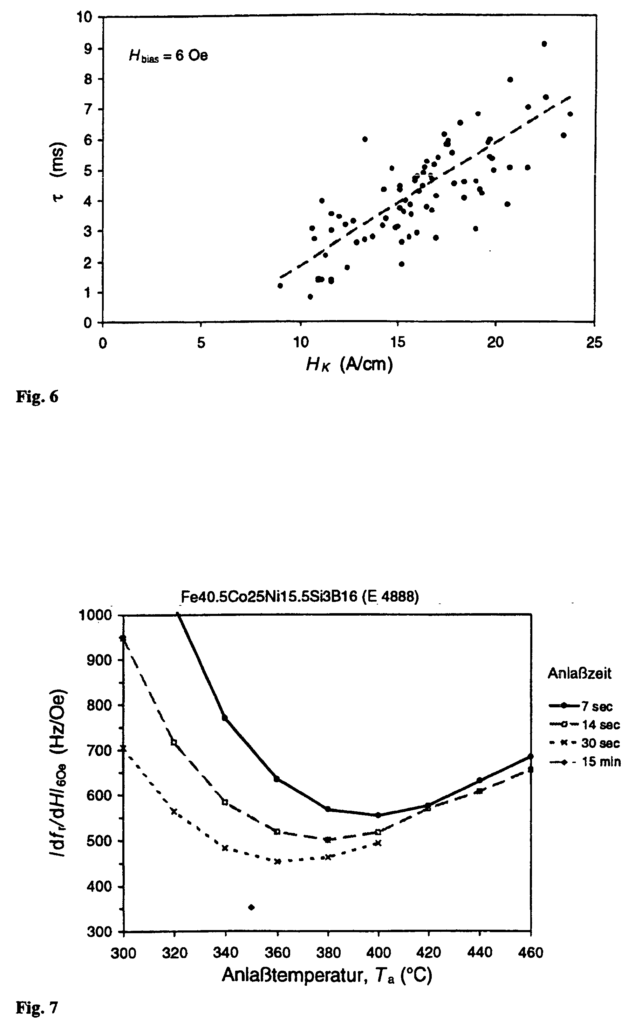

Figur 6    die Abklingzeit $\tau$ (bei 6 Oe) verschiedener, querfeldbehandelter Fe-Co-Si-B-Legierungen in Abhängigkeit der Anisotropiefeldstärke $H_K$,

Figur 7    die typische Abhängigkeit der Frequenzsteigung von der Anlaßtemperatur für verschiedene Anlaßzeiten,

Figur 8    Beispiele für die typische Abhängigkeit der Steigung der Resonanzfrequenz und des Anisotropiefeldes von (a) der Anlaßzeit und (b) der Anlaßtemperatur, und

Figur 9    den Einfluß der Bandbreite auf die Steigung der Resonanzfrequenz bei 6 Oe mit gefüllten Quadraten = experimentell für $Fe_{36,6}Co_{13}Ni_{34}Si_1B_{15}C_{0,4}$ (38 mm langer, 15$\mu$m dicker Streifen) und Linien = theoretische Abschätzungen für Banddicken von 20$\mu$m, 25$\mu$m und 30$\mu$m.

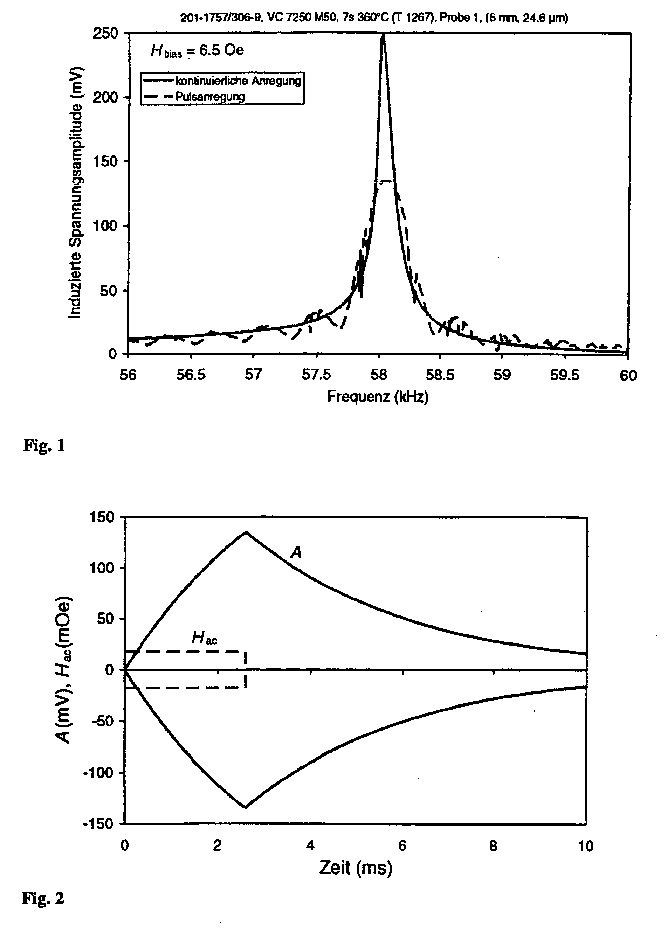

Kernstück eines Anzeigeelementes ist ein ferromagnetischer, magnetostriktiver Streifen, welcher durch ein magnetisches Wechselfeld zu longitudinalen, mechanischen Resonanzschwingungen angeregt wird. Aufgrund der magnetostriktiven Kopplung bewirken die mit der Schwingung verknüpften mechanischen Spannungen eine Magnetisierungsänderung, welche in der Empfängerspule eine entsprechende Spannung induziert, womit das Anzeigeelement nachgewiesen werden kann. Figur 1 illustriert die resonanzartige Überhöhung der induzierten Spannung als Funktion der Frequenz des erregenden Wechselfeldes.

Neben der Signalverstärkung durch Resonanzüberhöhung ist ein weiterer, entscheidender Vorteil dieser magnetoelastischen Diebstahlsicherungssysteme gegenüber konventionellen Diebstahlsicherungssystemen, daß die mechanische Schwingung und damit verknüpft die induzierte Spannung auch nach Abschalten der äußeren Erregung bestehen bleibt.

Das Signal hält typischerweise einige Millisekunden an. Figur 2 gibt eine schematische Darstellung. Dies ist ein mehr oder weniger einzigartiges Merkmal und reduziert mögliche Fehlalarme durch z.B. Einkaufswagen und andere magnetische Gegenstände auf ein absolutes Minimum. Da das anregende Magnetfeld in den Empfängerspulen ebenfalls eine Spannung induziert, ist ferner klar, daß die Empfindlichkeit des Systems erhöht wird, wenn dieser Störhintergrund wegfällt.

Entsprechend erfolgt die Anregung mit Wechselfeldpulsen, wobei während der Totzeit zwischen den Pulsen die Empfängerseite aktiv ist und versucht, das Anzeigeelement zu detektieren.

Hauptcharakteristikum eines Anzeigeelementes ist die Resonanzfrequenz des Streifens. Solche Resonanzfrequenzen liegen typischerweise um den Wert von 60 kHz. Das heißt, daß die Anregung der mechanischen Eigenschwingung und die damit verbundene resonanzartige Überhöhung der induzierten Spannung nur dann erfolgt, wenn der Streifen genau die Resonanzfrequenz besitzt.

Die Resonanzfrequenz $f_r$ eines länglichen Streifens wird in erster Linie durch seine Länge L bestimmt, d.h. es gilt

$$f_r = \frac{1}{2L}\sqrt{\frac{E_H}{\rho}} \tag{1}$$

wobei $E_H$ dem Elastizitätsmodul und $\rho$ die Dichte des Materials bezeichnen.

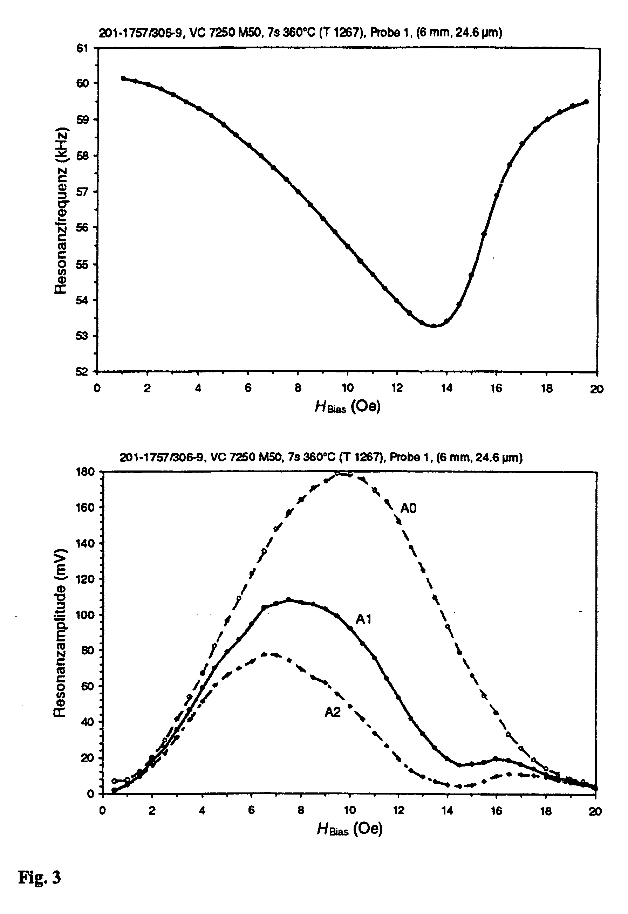

In ferromagnetischen Materialien hängt der Elastizitätsmodul und damit die Resonanzfrequenz auch vom Magentisierungszustand, d.h. von der Stärke eines von außen angelegten magnetischen Gleichfeldes ab. Dieser Umstand ist von zentraler Bedeutung für die Funktionsweise des Systems als auch für die Anforderung an das verwendete Magnetmaterial. Figur 3 gibt ein Beispiel für den typischen Verlauf der Resonanzfrequenz und der Signalamplitude als Funktion eines äußeren vormagnetisierenden Gleichfeldes an.

Typischerweise wird das vormagnetisierende Gleichfeld durch einen dem Resonatormaterial beigelegten hartmagnetischen Streifen erzeugt. Das Etikett ist aktiviert, wenn dieser hartmagnetische Streifen aufmagnetisiert ist. Der Wert des hierbei erzeugten Magnetfeldes beträgt typischerweise 6 bis 7 Oe (480 bis 560 A/m), welcher sich aus folgenden Forderungen ergibt:

1. Die relative Änderung des vormagnetisierenden Feldes durch unterschiedliche Streifenorientierungen bezüglich dem Magnetfeld der Erde (maximaler Wert 0,5 Oe) sollte möglichst klein sein, d.h. daß durch den hartmagnetischen Streifen erzeugte Feld sollte einen bestimmten Mindestwert haben.

2. Um eine zu starke magnetische Anziehung des Resonatorstreifens durch den Dauermagneten zu vermeiden, darf andererseits aber das durch diesen erzeugte Magnetfeld nicht zu groß sein.

Das Etikett wird dadurch deaktiviert, daß der halbharte Streifen entmagnetisiert wird, d.h. das vormagnetisierende Feld wird abgeschaltet. Hierdurch ergibt sich eine Verstimmung der Resonanzfrequenz und gleichzeitig ein deutlicher Abfall der Resonanzamplitude.

Die Anforderungen an das Resonatormaterial lassen sich demnach wie folgt zusammenfassen:

1. Eine hohe Signalamplitude und ein langes Anhalten des Signals nach Abschalten des erregenden Feldes;

2. eine lineare, flache Charakteristik der B-H-Schleife zur Vermeidung von Fehlalarmen in anderen Sicherungssystemen;

3. eine geringe Abhängigkeit der Resonanzfrequenz von der vormagnetisierenden Feldstärke;

4. gleichzeitig aber eine sichere Deaktivierungsmöglichkeit des mechanischen Schwingers, d.h. eine genügend große Änderung der Resonanzfrequenz beim Entfernen des vormagnetisierenden Feldes;

5. niedrige Kosten;

6. hinreichende Duktilität insbesondere nach der Wärmebehandlung, so daß eine mechanische Weiterverarbeitung, wie z.B. das Ablängen der Streifen, ohne Beeinträchtigung der magnetischen Eigenschaften möglich ist.

Im Folgenden werden diese Anforderungen näher diskutiert und die hierfür geeigneten Werkstoffe näher eingegrenzt.

Die magnetoelastischen Effekte setzen natürlich einen magnetostriktiven Werkstoff voraus. Die magnetostriktive Verzerrung $\varepsilon$ bezüglich des idealmagnetisierten Zustandes ist durch

$$\varepsilon = \frac{3}{2}\lambda_s\left(\cos^2\varphi - \frac{1}{3}\right) \tag{2}$$

gegeben, wobei $\lambda_s$ die Sättigungsmagnetostriktion und $\varphi$ den Winkel zwischen der Magnetisierung und der betrachteten Dehnungsachse bezeichnet. Eine magnetostriktive Längenänderung und somit eine magnetische Anregung von mechanischen Schwingungen ist damit nur möglich, wenn der Magnetisierungsprozeß über Drehprozesse abläuft. Dieser fordert magnetische Anisotropien schwer oder schräg zur Magnetisierungsrichtung. Letztere entspricht einem länglichen Bandstreifen aufgrund von Entmagnetisierungseffekten naturgemäß der Bandlängsrichtung.

Die Einstellung der magnetischen Anisotropien läßt sich prinzipiell bewerkstelligen durch:

1. Magnetoelastische Anisotropien verursacht durch innere, mechanische Spannungen, die z.B. vom Herstellprozeß herrühren oder durch partielle Oberflächenkristallisation induziert werden.

2. Induzierte Anisotropien durch Änderung der chemischen oder topologischen Nahordnung über Wärmebehandlung im Magnetfeld oder unter mechanischer Spannung.

An Legierungen kommen apriori praktisch die meisten ferromagnetischen, amorphen Legierungszusammensetzungen auf der Basis $(Fe\text{-}Co\text{-}Ni)_{\approx 70\text{-}87}(Si,B)_{\approx 14\text{-}30}$ mit den üblichen Zusätzen an Nb, Mo etc. oder C, P etc. Außer nahezu magnetostriktionsfreie Co-Ni-Basislegierungen mit Fe-Gehalten bis zu etwa 10 bis 15 Atom-%, welche hier auszuschließen sind, weisen diese fast beliebig kombinierbare Zusammensetzungen eine hohe Sättigungsmagnetostriktion von typischerweise $\lambda_s \approx 10$ bis 40 ppm auf. Die Eingrenzung der für die Anwendung in Frage kommenden Legierungen ergibt sich primär aus der geeigneten Einstellbarkeit der eben erwähnten magnetischen Anisotropien.

Insbesondere wird im Stand der Technik die amorphe ferromagnetische Legierung $Fe_{40}Ni_{38}Mo_4B_{18}$ verwendet, die aus der WO 90/03652 bekannt ist. An dieser Legierung ist aber nachteilig, daß sie zu anderen Diebstahlsicherungssystemen nicht kompatibel ist, wobei diese anderen Diebstahlsicherungssysteme auf der Detektion von Oberwellen basieren. So erzeugt ein auf dieser Legierung basierendes magnetoelastisches Anzeigeelement im deaktivierten Zustand bei Wechselfeldanregung Oberwellen und löst somit in den ebengenannten Sicherungssystemen einen Fehlalarm aus. Grund hierfür ist die Nichtlinearität der B-H-Schleife, welche letztlich aus der Verteilung der herstellbedingten inneren Spannungen resultiert.

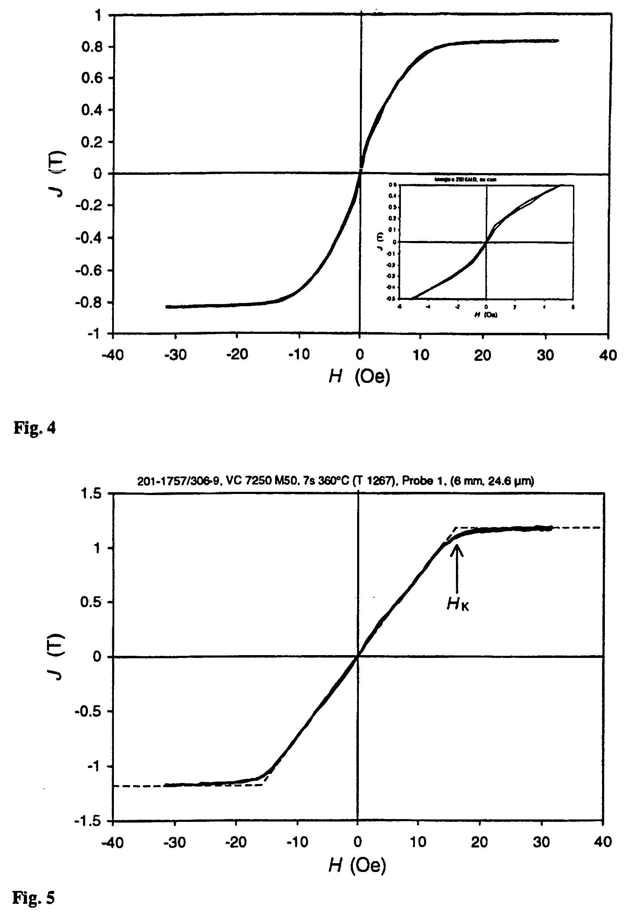

In Figur 4 ist die B-H-Schleife dieser Legierung gezeigt. Insbesondere der bei kleinen Feldstärken um Oe auftretende innere Knick in der B-H-Schleife ist verantwortlich für die Erzeugung von Oberwellen in herkömmlichen Diebstahlsicherungssystemen. Nachteilig an der Ausnutzung innerer mechanischer Spannungen ist ferner, daß dies eine extrem genaue Kontrolle der Herstellbedingungen erfordert.

Ferner besteht die Möglichkeit durch partielle Kristallisation der Bandoberfläche, eine Anisotropie senkrecht zur Bandebene und damit senkrecht zur Bandlängsrichtung einzustellen. Hierbei läßt aber in der Regel die Linearität der Schleife zu wünschen übrig. Ein entsprechendes Verfahren ist aus der WO 93/09549 bekannt. Dabei wird ausdrücklich auf eine diskontinuierliche, d.h. nichtlineare, zentrale B-H-Schleife abgestellt bzw. es wird deutlich darauf hingewiesen, daß das Resonanzverhalten im teilkristallinen Zustand deutlich besser sei als bei der selben Legierung im amorphen Zustand. Hinsichtlich der Einstellung einer flachen Schleife durch partielle Kristallisation ist letztlich zu bemerken, daß die Eigenschaften sehr empfindlich vom genauen Grad der partiellen Kristallisation abhängig sind und damit nur relativ schwer reproduzierbar sind.

Das Eintempern einer uniaxialen induzierten Anisotropie quer zur Bandlängsrichtung beseitigt obengenannte Probleme. Zum einen werden durch die Wärmebehandlung die von den Zufälligkeiten des Herstellprozesses herrührenden inneren Spannungen weitgehend relaxiert und die Stärke der Anisotropie kann durch Wahl der Legierungszusammensetzung und der Anlaßparameter sehr genau kontrolliert werden.

Zum anderen ist bekannt, daß eine uniaxiale Anisotropie quer zur Bandlängsrichtung eine bis zur ferromagnetischen Sättigung sehr lineare B-H-Schleife ergibt. Ein Beispiel dafür ist aus der Figur 5 zu sehen.

Somit werden in herkömmlichen Diebstahlsicherungssystemen keine Oberwellen erzeugt, d.h. es werden dort keine Fehlalarme ausgelöst.

Zur Einstellung einer entsprechenden Anisotropie quer zur Bandrichtung eignet sich erfahrungsgemäß am besten die Temperung in einem quer zur Bandrichtung und in der Bandebene liegenden Magnetfeld. Daneben besteht prinzipiell noch die Möglichkeit das Band unter mechanischer Zugspannung anzulassen, was allerdings nicht bei allen Legierungen zu einer Quer- sondern zu einer Längsanisotropie führen kann.

Für eine uniaxiale Queranisotropie läßt sich das magnetoelastische Verhalten praktisch vollständig theoretisch beschreiben. So sind für Magnetfelder $H$ unterhalb des Anisotropiefeldes $H_K$ der Elastizitätsmodul, $E_H$, durch

$$\frac{E_H}{E_s} = \frac{1}{1 + \dfrac{9\lambda_s^2 E_s}{J_s H_K^3} H^2}, \tag{3}$$

die Abklingzeit $\tau$ der Schwingung (oder Nachschwingzeit) bzw. die Dämpfung $1/\tau$ der Schwingung durch

$$\frac{1}{\tau} = \frac{1}{\tau_0} + \frac{(\pi f_r d)^2}{6\rho_{el}} \frac{J_s}{H_K} \frac{1 - E_H / E_s}{1 - (H / H_K)^2} \tag{4}$$

und die Einhüllende der Resonanzamplitude A(t) bei pulsförmiger Anregung durch

$$V(t) = 16\, N\, b\, d\, f_r^2 H_{ac} \frac{J_s}{H_K}(1 - \frac{E_H}{E_s})\,\tau\,[1 - \exp(-t_P/\tau)] \cdot \exp(-t/\tau)$$

$$\underset{\substack{\tau_0\,sehr\,groß,\\ H>0}}{\approx} \frac{96}{\pi^2}\, N\, \frac{b}{d}\,\rho_{el} H_{ac}(1 - \frac{H^2}{H_K^2})\,[1 - \exp(-t_P/\tau)] \cdot \exp(-t/\tau) \tag{5}$$

gegeben. Dabei bezeichnen

| | |
|---|---|
| $H$ | das äußere magnetische Gleichfeld |
| $H_K$ | die Anisotropiefeldstärke |
| $E_H$ | den Elastizitätsmodul in einem Magnetfeld der Stärke $H$ |
| $E_s$ | den Elastizitätsmodul in der ferromagnetischen Sättigung |
| $\lambda_s$ | die Sättigungsmagnetostriktion |
| $J_s$ | die Sättigungsmagnetisierung |
| $f_r$ | die Resonanzfrequenz |
| $\rho_{el}$ | den spezifischen elektrischen Widerstand |
| $d$ | die Banddicke |
| $1/\tau_0$ | die rein mechanische bedingte Dämpfung |
| $N$ | die Windungszahl der Pick-up-Spule |
| $b$ | die Bandbreite |
| $t_p$ | die Dauer des anregenden Feldpulses |
| $t$ | die Zeit ab dem Ausschalten der magnetischen Anregung |

Die gesamte Anisotropiefeldstärke $H_K$ des Streifens, d.h. die Knickfeldstärke bei der die Schleife in die Sättigung geht, setzt sich gemäß

$$H_K = H_A + N\,J_a\,/\mu_0 \tag{6a}$$

zusammen aus dem durch die Wärmebehandlung induzierten Anisotropiefeld $H_A$ und dem Anisotropiebeitrag $N\,J_a\,/\mu_0$ des Entmagnetisierungsfaktors $N$ der Probe. Letzterer läßt sich in sehr guter Näherung durch denjenigen eines flachen Ellipsoides beschreiben, wobei für die Halbachsen die Werte für Bandbreite $b$, Banddicke $d$ und *Streifenlänge l* einzusetzen sind. Es gilt dann für $1 \geq b >> d$

$$N = \frac{db}{l^2 - b^2}\left[K(1 - \frac{b^2}{l^2}) - E(1 - \frac{b^2}{l^2})\right] \tag{6b}$$

wobei K und E die vollständigen elliptische Integrale erster und zweiter Art bezeichnen. Somit ergibt sich über den Entmagnetisierungsfaktor eine zusätzlicher Einfluß der Bandgeometrie auf die magnetoelastischen Eigenschaften, welcher bislang offenbar praktisch kaum bekannt war bzw. berücksichtigt wurde.

Die Abklingzeit, d.h. die Dämpfung des Signals wird bestimmt durch die rein mechanische Dämpfung (phänomenologisch durch den Parameter $1/\tau_0$ beschrieben) der Schwingung, sowie durch Wirbelströme (beschrieben durch den zweiten Term in G1. (4)). Bei endlicher Vormagnetisierung dominiert in der Regel der Beitrag der Wirbelstromdämpfung, womit sich die Resonanzamplitude durch den zweiten Ausdruck in G1. (5) approximieren läßt.

Die Abhängigkeit des Elastizitätsmoduls von den Materialparametern und dem angelegten Magnetfeld ist im Prinzip bekannt. Mit der bekannten Abhängigkeit für eine ideale, uniaxiale Anisotropie lassen sich die experimentellen Daten für die Resonanzfrequenz in Abhängigkeit der Feldstärke für H < $H_k$ sehr gut vorhersagen. Das Minimum des Elastizitätsmoduls bzw. der Resonanzfrequenz liegt im Idealfall bei der Anisotropiefeldstärke $H_k$, im Realfall aufgrund von Einmündungseffekten in die Sättigung etwas darunter.

Primäre Forderung an Diebstahlsicherungssysteme ist die Vermeidung von Fehlalarmen, d.h. die sichere Deaktivierbarkeit des Anzeigeelements. Dafür ist eine gewisse Mindeständerung der Resonanzfrequenz beim Deaktivieren, d.h. beim Abschalten des Vormagnetisierungsfeldes $H_{bias}$. Der absolute Mindestwert von $\Delta f_r$ und damit der Bedingung, daß durch das deaktivierte Anzeigeelement kein Fehlalarm ausgelöst wird, beträgt $\Delta f_r > 1,2$ kHz. Als im statistischen Mittel besonders gut hat sich der Wert 1,75 kHz erwiesen.

Eine weitere Bedingung ist, daß die Eigenfrequenz des vormagnetisierten Streifens so wenig wie möglich von der Stärke des vormagnetisierenden Gleichfeldes abhängt. So ergibt sich allein durch verschiedene Orientierungen des Streifens im Magnetfeld der Erde Änderungen der Arbeitsfeldstärke von ± 0,5 Oe (± A/m). Hinzu kommen Änderungen der gleichen Größenordnung durch Materialstreuungen des in der Regel verwendeten vormagnetisierenden halbharten Streifens. Aufgrund der Abhängigkeit der Resonanzfrequenz von der Größe des vormagnetisierenden Gleichfeldes führt dies zu Änderungen der Eigenfrequenz des schwingenden Streifens. Sind diese Änderungen zu groß, so wird der Streifen der Abfragezone des Diebstahlsicherungssystems nicht mehr richtig erkannt, da die Resonanzfrequenz ein typisches Kennzeichen des Streifens ist. Dementsprechend muß im Arbeitspunkt die Änderung der Resonanzfrequenz $df_r$ gegenüber der Änderung der Vormagnetisierungsfeldstärke dHx unterhalb eines bestimmten Grenzwertes liegen. Dementsprechend ist für den Betrag der Frequenzsteigung mit dem Feld ein oberer Grenzwert von $|df_r/dH|$ (bei H = 6 Oe) $\leq$ 800 Hz/Oe besonders geeignet. Diese Bedingung steht für eine gute Alarmauslöserate der aktivierten Anzeigeelemente.

Es ist evident, daß die beiden genannten Forderungen aufgrund des prinzipiellen Verlaufs der Resonanzfrequenz (siehe Figur 3) einander gegenläufig sind. Letztlich besteht ein relativ eindeutiger Zusammenhang zwischen $\Delta f_r$ und $|df_r/dH_K|$, welcher von den Details der Legierungszusammensetzung weitgehend unabhängig ist und in guter Näherung durch $\Delta f_r \approx 0,5$ $H|df_r/dH_K|$ gegeben ist.

Dementsprechend entspricht damit die Anforderung an $\Delta f_r$ letztlich einem unteren Grenzwert für die Steigung $|df_r/dH_K|$, der sich durch 400 Hz/Oe $\leq$ $|df_r/dH_K|$ (H = 6 Oe $\leq$ 800 Hz/Oe) allein auf die Spezifikation der Frequenzsteigung reduziert.

Der obige Wert von 400 Hz pro Oe entspricht dabei dem untersten Grenzwert, der zur Vermeidung von Fehlalarmen unbedingt einzuhalten ist. In der Praxis werden sicherlich höher angesetzte Grenzwerte von ungefähr 550 oder 600 Hz pro Oe angenommen. Diese berücksichtigen im wesentlichen die Materialtoleranzen des halbharten Materials und garantieren, daß auch bei größeren Materialschwankungen das deaktivierte Anzeigeelement keinen Fehlalarm auslöst.

Es ergibt sich so für das Streifenmaterial ein enger Toleranzbereich, welcher naturgemäß das Spektrum der brauchbaren Legierungen sehr stark einengt.

Anzumerken ist, daß $|df_r/dH_{bias}|$ und $df_r$ natürlich mit der Vormagnetisierungsfeldstärke sich ändern. Die hier angegebenen Grenzwerte gelten deshalb nur für eine Vormagnetisierungsfeldstärke von 6 Oe. Ändert man diese Vormagnetisierungsfeldstärke von 6 Oe zu anderen Feldstärken, so ändern sich diese Grenzwerte natürlich. Die neuen Grenzwerte sind relativ eindeutig mit obengenannten verknüpft und können anhand von bekannten physikalischen Beziehungen neu berechnet werden. Als empirische Formel hat sich dabei ergeben, daß im Bereich um 6 Oe bei einer Felderhöhung um 1 Oe die Frequenzsteigung um ca. 60 bis 80 Hz pro Oe zunimmt.

Ziel der Legierungsoptimierung ist es nun, eine Legierungszusammensetzung zu finden, welche bei vorgegebener Bandgeometrie nach Wärmebehandlung im Magnetfeld eine Steigung der Resonanzfrequenz um 600 Hz/Oe (bei 6 Oe) aufweist.

Als relevante Einflußgrößen verbleiben die Sättigungsmagnetostriktion $\lambda_s$, die Sättigungsmagnetisierung $J_s$ und das Anisotropiefeld $H_K$.

Sowohl $\lambda_s$ und $J_s$ sind primär durch die Legierungszusammensetzung bestimmt und werden von der Wärmebehandlung kaum beeinflußt. Das Anisotropiefeld $H_K$ hingegen wird sowohl von der Legierungszusammensetzung und der Wärmebehandlung, als auch von den Streifenabmessungen bestimmt. Es bildet zudem den stärksten Einflußfaktor, da es mit der dritten Potenz in die Frequenzsteigung eingeht.

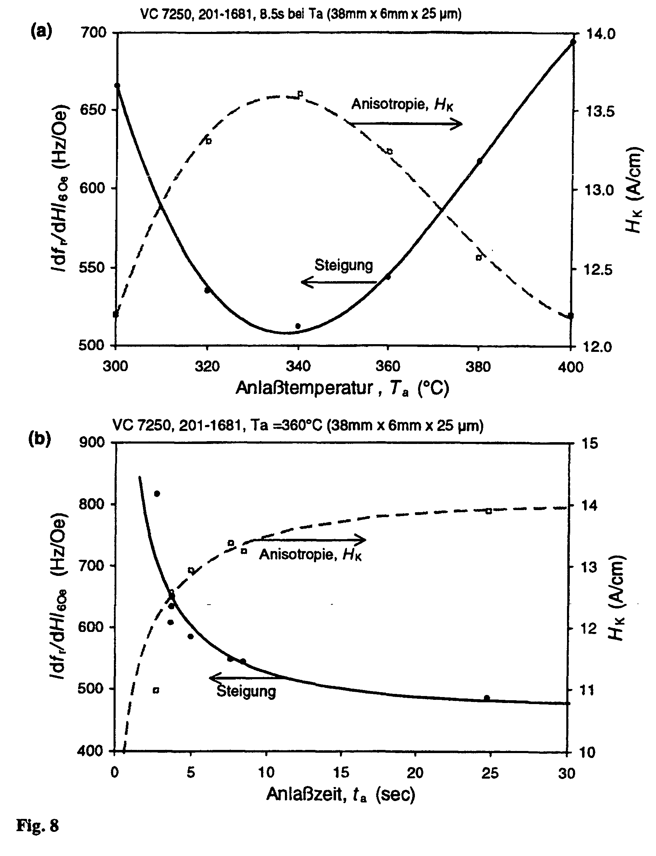

Die Figur 8 gibt einen Überblick über den letztlichen Einfluß von Zusammensetzung und Wärmebehandlung auf die Frequenzsteigung, welcher im folgenden näher diskutiert wird.

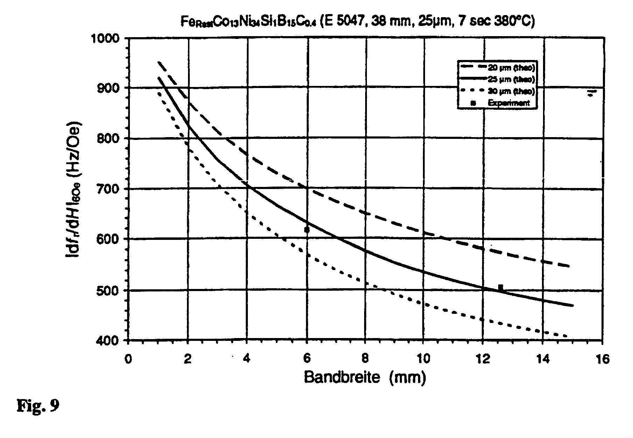

Die Abhängigkeit der Frequenzsteigung von den Wärmebehandlungsparametern resultiert letztendlich aus der entsprechenden Abhängigkeit des Anisotropiefeldes, was aus der Figur 9 hervorgeht.

Den Haupteinfluß bei der Wärmebehandlung bilden die Anlaßzeit und die Anlaßtemperatur. Das Anlaßverhalten der Frequenzsteigung läßt sich hierbei generell wie folgt charakterisieren:

Für Anlaßtemperaturen im Bereich von etwa 320°C bis 400°C ergibt sich ein Minimum der Frequenzsteigung, dessen genaue Lage durch die Anlaßzeit und die Legierungszusammensetzung bestimmt ist. Der Einfluß der Anlaßzeit ist umso ausgeprägter, je niedriger die Anlaßtemperatur ist. Für hohe Temperaturen erreicht die Frequenzsteigung ihren Gleichgewichtswert bereits innerhalb weniger Sekunden.

Wie aus den Figuren 8 und 9 hervorgeht, läßt sich durch geeignete Wahl der Anlaßparameter die Frequenzsteigung prinzipiell in einem relativ weiten Bereich von etwa ± 50 % variieren.

Dieser weite Bereich läßt sich jedoch in der Praxis aus folgenden Gründen nur beschränkt ausnützen.

1. Die Randbedingungen einer linearen Schleife, einer langen Nachschwingzeit, einer hohen Signalamplitude und guter Reproduzierbarkeit erfordern eine weitgehende Relaxation der herstellbedingten inneren Spannungen, was letztlich nur bei erhöhten Anlaßtemperaturen von etwa ab 340°C zuverlässig der Fall ist.

2. Das wärmebehandelte Band sollte nach Möglichkeit weitgehend duktil sein, so daß die Streifen auch nach der Wärmebehandlung abgelängt werden können und so die Länge ebenfalls genau an die erforderliche Resonanzfrequenz angepaßt werden kann. Neben Legierungsmaßnahmen erfordert dies relativ kurze Anlaßzeiten und nicht zu hohe Anlaßtemperaturen, auch um eine Kristallisation des Bandes zu vermeiden.

Am besten bewährt haben sich diesbezüglich Anlaßtemperaturen im Bereich von etwa 340 bis 420°C und Anlaßzeiten von wenigen Sekunden. Für die reproduzierbare Durchführung dieser Kurzzeitbehandlungen eignet sich am besten eine Durchlaßglühung. Die Länge der Glühzone variiert hierbei zwischen ca. 20 cm und 2 m.

Prinzipiell sind auch stationäre Temperungen im Minuten- bis Stundenbereich möglich.

Die Stärke des während der Wärmebehandlung angelegten Magnetfeldes ist relativ irrelevant, so lange gewährleistet ist, daß sie hoch genug ist, um das Material ferromagnetisch zu sättigen. Theoretisch genügen hier Felder je nach Bandbreite und Dicke von mindestens 100 Oe bei einem 6 mm breiten und 25 μm dicken Band bzw. 300 Oe bei einem 2 mm breiten und 30 μm dicken Band. In den vorliegenden Ausführungsbeispielen wurden je nach verwendetem Ofen, Feldstärken von 1 bis 2 kOe eingesetzt.

Erfolgt die Wärmebehandlung im Durchlauf, so kommt als weiterer Anlaßparameter die Zugspannung dazu. Beim Tempern unter Zugspannung entsteht eine spannungsinduzierte Anisotropie, deren Anisotropie je nach Zusammensetzung quer oder längs zur Zugachse ist und somit das Anisotropiefeld leicht verstärken bzw. abschwächen kann. In der Praxis liegen die auftretenden Zugspannungen meist unter 100 MPa Ihre Ursache liegt in der mechanischen Reibung zwischen Band und Bandführung. Dies ist insbesondere der Fall, wenn dem Band durch entsprechende Führung eine Querkrümmung eingetempert werden muß.

Die Wahl der Anlaßparameter bietet zwar eine gewisse Variationsmöglichkeit bei der Einstellung der Frequenzsteigung, das erzielbare Niveau wird jedoch letztlich entscheidend durch die Legierungszusammensetzung bestimmt.

Da das Ziel eine möglichst kleine Frequenzsteigung ist, ist es bei der Optimierung der Zusammensetzung am sinnvollsten den Minimalwert der erzielbaren Frequenzsteigung zu betrachten.

Startpunkt war eine Variation der Co-Gehalte und der Metalloidgehalte.

Ein Ausgleich der durch die Kobaltreduktion bedingten Erhöhung der Frequenzsteigung durch weitere Reduktion des Metalloidgehaltes ist kaum möglich. Grund dafür ist, daß es eines Mindestgehaltes an Silizium und Bor von zusammen ca. 14 Atom-% bedarf, damit das Band amorph erstarrt.

Unter der Randbedingung einer kleinen Frequenzsteigung läßt sich der Kobaltgehalt somit nur erniedrigen, wenn man Kobalt durch Nickel substituiert. Auf diese Weise ist eine Reduktion des Kobaltgehaltes bis ca. 8 Atom-% möglich. Bei noch kleineren Kobaltgehalten steigt die Frequenzsteigung wieder stark an.

Hieraus ergibt sich ein hinsichtlich kleiner Kobaltgehalte optimierter Legierungsbereich der ungefähren Zusammensetzung $Fe_{rest}Co_{\approx 10-15}Ni_{\approx 30-35}Si_{\approx 1}B_{15-16}$.

Da in das die Frequenzsteigung bestimmende Anisotropiefeld, neben der rein feldinduzierten Anisotropie auch die vom Entmagnetisierungsfaktor abhängige Formanisotropie eingeht, sind die magnetoelastischen Eigenschaften nicht nur von der Zusammensetzung, sondern auch von der Geometrie des Bandstreifens abhängig. Da die frequenzbestimmende Länge mehr oder weniger vorgegeben ist, betrifft dies in erster Linie den Einfluß von Bandbreite und insbesondere Banddicke.

Für einen 38 mm langen und 25 μm dicken Streifen folgt bei einer Fertigungsmagnetisierung von Js = 1 Ts, ein entmagnetisierendes Feld von H ≈ 2,4 Oe für einen 6 mm breiten Streifen bzw. H ≈ 3,5 Oe für einen 12,5 mm breiten Streifen. Dieser Wert addiert sich zu der reinen feldinduzierten Anisotropie.

Der Wert des entmagnetisierenden Feldes ist zwar deutlich kleiner als die reine feldinduzierte Anisotropie, jedoch groß genug, um eine signifikante Änderung des gesamten Anisotropiefeldes $H_K$ zu bewirken. Entsprechend ergibt sich die in Figur 9 gezeigte Abhängigkeit der Frequenzsteigung von der Bandbreite und der Banddicke.

Die Banddicke kann herstellbedingt im Bereich 20 bis 30 μm variiert werden. Die Bandbreite muß kleiner als die Resonatorlänge sein und kann bis etwa 0,5 mm abgesenkt werden.

Die Auswahl von Bandbreite und Banddicke ergibt sich zweckmäßigerweise letztlich aus einem Kompromiß zwischen vernünftig hoher Signalamplitude und Materialkosten.

Während die Signalamplitude streng proportional zur Bandbreite anwächst, gilt dies nicht zwangsweise für die Banddicke, da mit abnehmender Banddicke die für die Dämpfung maßgeblichen Wirbelstromverluste zurückgehen.

Die Änderung von Nominalbreite- und dicke erfordert immer eine Feinanpassung der Legierungszusammensetzung, damit wieder die gewünschte Frequenzsteigung erzielt wird.

Die nachfolgende Tabelle 1 enthält Werte zu zwei verschiedenen bekannten Legierungen. Die Legierung unter den Nr. 1 und 2 ist dabei aus der bereits genannten Wo 90/03652 bekannt, während die Legierung unter Nr. 3 in DE-GM 9412456 erwähnt ist. Die Versuche bezüglich der Nr. 1 und 2 sind an der gleichen Legierung vorgenommen worden. Dabei wurde als Beispiel Nr. 1 die Legierung im Herstellzustand und unter Nr. 2 und 3 die Legierung nach. einer Wärmebehandlung untersucht, durch die eine lineare, flache Schleife eingestellt wurde:

Tabelle 1

| Nr | Zusammensetzung (at%) | Co (wt%) | $|df_r/dH_{bias}|$ (H) (kHz) | $\Delta fr$ (kHz) | U (mV) | $\tau_R$ (ms) |
|---|---|---|---|---|---|---|
| 1 | Fe-40 Ni-38-Mo-4 B-18 | - | 0.34 -0.72 | 1.94 - 3.51 | 150 | 4 |
| 2 | Fe-40 Ni-38-Mo-4 B-18 | - | 1.04 - 1.65 | 6.55 - 6.84 | 20 | 1.3 |
| 3 | Fe-39.5 Co-39.5 Si-6 B-15 | 47.9 | 0.79 - 1.44 | 2.43 - 4.92 | 220 | 5.2 |

Man sieht, daß das Beispiel Nr. 1 je nach untersuchter Probe eine Änderung der Resonanzfrequenz $df_r$ gegenüber der Änderung der Vormagnetisierungsfeldstärke $dH_{bias}$ unterhalb von 1 kHz besitzt, während die Änderung der Resonanzfrequenz bei Entfernung bzw. bei Hinzufügung eines Vormagnetisierungsfeldes $\Delta fr$ eine Änderung der Resonanzfrequenz von mehr als 1,94 aufweist. Auch die Signalhöhe mit 150 mV und die Schwingungsdauer ist für den Einsatz in Überwachungssystemen mit mechanisch schwingenden Etiketten ausreichend.

Der Nachteil dieser Legierung besteht allerdings darin, daß in der Magnetisierungsschleife sprungartige Remanenzänderungen vorkommen, die einen Fehlalarm auslösen, wenn ein Sicherungsetikett mit einem derartigen Überwachungsstreifen durch ein Überwachungsfeld einer Diebstahlsicherungsanlage geführt wird, die zur Erkennung die durch ein Wechselfeld erzeugten Oberwellen ausnutzt.

Nach einer Wärmebehandlung zur Erzielung einer flachen, linearen Schleife ergeben sich bei der gleichen Legierung die unter Nr. 2 angegebenen Werte. Man sieht, daß die Abhängigkeit vom Erdfeld wesentlich größer geworden ist, da die Schwankungen der Resonanzfrequenz bei Lageänderung des Streifens über 1 kHz liegt. Obgleich der Abstand zu der Änderung der Resonanzfrequenz bei Entfernung des Vormagnetisierungsfeldes mit über 6 kHz ausreicht, ist ein solches Band für mechanisch schwingende Etiketten nicht sehr gut geeignet - insbesondere wegen der niedrigen Signalhöhe von 20 mV und der kurzen Abklingzeit des schwingenden Streifens.

Die Legierung unter Nr. 3 der Tabelle 1 weist wiederum, wie diejenige unter Nr. 1 eine ausreichend niedrige Schwankung der Resonanzfrequenz bezüglich einer Änderung der Vormagnetisierungsfeldstärke, und liegt auch in den übrigen Werten, Änderung der Resonanzfrequenz bei Entfernung des Vormagnetisierungsfeldes, Signalspannung und Abklingzeit, in einem gut brauchbaren Bereich. Der Ersatz von Nickel durch Kobalt hat aber dazu geführt, daß in Gew.-% ein Kobaltgehalt von 47,9 in der Legierung enthalten ist, so daß diese Legierung wegen des relativ hohen Kobaltpreises für eine Massenanwendung wirtschaftliche Nachteile bietet.

Erfindungsgemäß wurde erkannt, daß amorphe Legierungen, die sowohl Eisen als auch Kobalt und Nickel enthalten, und deren Metalloidanteil (Si, B) bestimmte Werte nicht überschreitet, folgende Eigenschaften haben können:

1. eine hohe Signalamplitude und langes Anhalten des Signals nach Abschalten des erregenden Feldes;

2. eine lineare, flache Charakteristik der Magnetisierungsschleife zur Vermeidung von Fehlalarmen in anderen Sicherungsanordnungen;

3. eine geringe Abhängigkeit der Resonanzfrequenz von der vormagnetisierenden Feldstärke;

4. eine sichere Deaktivierungsmöglichkeit des mechanischen Schwingers bei Entfernen dees vormagnetisierenden Feldes durch ausreichende Änderung der Resonanzfrequenz und Signalhöhe;

5. niedrige Rohstoffkosten durch möglichst kleinen Co-Gehalt;

6. eine Duktilität nach Wärmebehandlung, die ein Biegen des Streifens auf einen Durchmesser von weniger als 2 mm gestattet, ohne daß anschließend die Signalhöhe wesentlich beeinträchtigt wird.

Beispiele erfindungsgemäßer Legierungen sind in der Tabelle 2 unter Nr. 4 bis 27 nachstehend aufgeführt:

Tabelle 2

| Nr | Zusammensetzung (at%) | Co (wt%) | $|df_r/dH_{bias}|$ (kHz/Oe) | $\Delta fr$ (kHz) | U (mV) | $\tau_R$ (ms) |
|---|---|---|---|---|---|---|
| 4 | Fe-49 Co-6 Ni-27 Si-2 B-16 | 7.2 | 0.78 - 1.39 | 2.41 -5.16 | 151 | 5.3 |
| 5 | Fe-47 Co-10 Ni-25 Si-2 B-16 | 12.0 | 0.69 - 1.22 | 2.11 -4.52 | 187 | 6.0 |
| 6 | Fe-41 Co-10 Ni-31 Si-2 B-16 | 12.0 | 0.51 - 0.93 | 1.54 -3.31 | 137 | 6.2 |
| 7 | Fe-36 Co-10 Ni-36 Si-2 B-16 | 11.9 | 0.58 - 1.05 | 1.81 -3.88 | 172 | 6.6 |
| 8 | Fe-31 Co-10 Ni-41 Si-2 B-16 | 11.9 | 0.65 - 1.17 | 2.01 -4.31 | 185 | 5.6 |
| 9 | Fe-51.5 Co-11.5 Ni-20 Si-1 B-16 | 13.7 | 0.56 - 1.02 | 1.72 -3.70 | 157 | 6.0 |
| 10 | Fe-41.5 Co-11.5 Ni-30 Si-1 B-16 | 13.7 | 0.41 - 0.74 | 1.25 -2.69 | 129 | 10.2 |
| 11 | Fe-49.5 Co-13 Ni-20 Si-1.5 B-16 | 15.6 | 0.53 - 0.94 | 1.57 -3.41 | 173 | 9.2 |
| 12 | Fe-44.5 Co-13 Ni-25 Si-1.5 B-16 | 15.5 | 0.47 - 0.83 | 1.39 -3.01 | 158 | 7.9 |
| 13 | Fe-39.5 Co-13 Ni-30 Si-1.5 B-16 | 15.5 | 0.41 - 0.74 | 1.23 -2.66 | 139 | 8.5 |
| 14 | Fe-34.5 Co-13 Ni-35 Si-1.5 B-16 | 15.4 | 0.38 - 0.71 | 1.15 -2.43 | 120 | 9.9 |
| 16 | Fe-29.5 Co-13 Ni-40 Si-1.5 B-16 | 15.4 | 0.45 - 0.80 | 1.36 -2.93 | 141 | 7.4 |
| 17 | Fe-28 Co-13 Ni-41 Si-2 B-16 | 15.4 | 0.59 - 1.06 | 1.79 -3.86 | 167 | 6.4 |
| 18 | Fe-44 Co-16 Ni-22 Si-2 B-16 | 19.2 | 0.39 - 0.72 | 1.16 -2.51 | 145 | 9.9 |
| 19 | Fe-40 Co-16 Ni-26 Si-2 B-16 | 19.1 | 0.44 - 0.80 | 1.34 -2.89 | 160 | 9.7 |
| 20 | Fe-28 Co-16 Ni-38 Si-2 B-16 . | 19.0 | 0.45 - 0.81 | 1.32 -2.87 | 139 | 7.3 |
| 21 | Fe-40.5 Co-20.5 Ni-20 Si-3 B-16 | 24.6 | 0.38 - 0.71 | 1.12 -2.46 | 147 | 10.3 |
| 22 | Fe-51 Co-21 Ni-10 Si-2 B-16 | 25.2 | 0.58 - 1.03 | 1.75 -3.75 | 203 | 7.7 |
| 23 | Fe-46 Co-21 Ni-15 Si-2 B-16 | 25.2 | 0.43 - 0.78 | 1.30 -2.83 | 123 | 7.1 |
| 24 | Fe-43 Co-21 Ni-18 Si-2 B-16 | 25.1 | 0.37 - 0.68 | 1.10 -2.38 | 115 | 9.0 |
| 25 | Fe-41 Co-21 Ni-20 Si-2 B-16 | 25.1 | 0.31 - 0.59 | 0.93 -2.00 | 100 | 11.9 |
| 26 | Fe-41 Co-21 Ni-20 Si-1 B-17 | 25.2 | 0.31 - 0.56 | 0.89 -1.94 | 108 | 12.1 |
| 27 | Fe-40.5 Co-21 Ni-20 Si-2.5 B-16 | 25.2 | 0.36 - 0.67 | 1.13 -2.40 | 103 | 9.8 |

Die Beispiellegierungen wurden zur Einstellung der flachen, linearen Schleife einer Wärmebehandlung in einem magnetischen Querfeld unterworfen. Typische Anlaßtemperaturen reichten dabei von 280 bis 440°C. Die Anlaßzeiten lagen im Bereich von wenigen Sekunden bis mehrere Stunden. Die genaue Wärmebehandlung bedingt einen typischen Variationsbereich für die Größen $\Delta fr$ und $|df_r/dH_{bias}|$, welcher in obenstehender Tabelle angezeigt ist. Die Untersuchungen wurden an Streifen mit einer Länge von 40 mm durchgeführt. Die typischen Resonanzfrequenzen lagen im Bereich 50-60 kHz.

Alle genannten Beispiele besitzen eine lineare Schleife, eine hohe Signalamplitude über 100 mV, eine Abklingzeit von einigen ms und es läßt sich eine Frequenzstreuung $\Delta fr$ < 1 kHz, sowie eine genügend hohe Frequenzänderung von fr(0)-fr(H) > 1 kHz nach Entmagnetisierung realisieren. Ferner weisen die Legierungen nach Wärmebehandlung das für die Weiterverarbeitung nötige duktile Verhalten auf. Besonders vorteilhaft sind die Beispiele 4-17, da sie einen Co-Anteil deutlich unter 20 Gew.-% besitzen und somit die gewünschten Eigenschaften bei geringen Rohstoffkosten realisieren.

Zur Verdeutlichung zeigt die nachfolgende Tabelle 3 einige Zusammensetzungen, welche die Aufgabe der Erfindung nicht lösen:

Tabelle 3

| Nr | Zusammensetzung (at%) | Co (wt%) | $\lvert df_r/dH_{bias} \rvert$ (kHz/Oe) | $\Delta fr$ (kHz) | U (mV) | $\tau_R$ (ms) |
|---|---|---|---|---|---|---|
| 28 | Fe-41.5 Ni-41.5 Si-1 B-16 | - | 1.38 -2.33 | 4.63 -9.68 | 144 | 2.4 |
| 29 | Fe-52 Ni-30 Si-2 B-16 | - | 1.25 -2.19 | 4.14 -8.72 | 192 | 2.9 |
| 30 | Fe-57 Ni-25 Si-2 B-16 | - | 1.49 -2.56 | 5.04 -10.52 | 203 | 2.8 |
| | | | | | | |
| 31 | Fe-65 Co-18 Si-1 B-16 | 21.7 | 1.42 -2.39 | 4.72 -9.82 | 178 | 2.8 |
| 32 | Fe-61.5 Co-21.5 Si-1 B-16 | 25.8 | 0.98 -1.76 | 3.12 -6.64 | 195 | 3.9 |
| 33 | Fe-47.4 Co-31.6 Si-2 B-19 | 39.0 | 1.01 -1.75 | 3.31 -6.93 | 197 | 4.1 |
| | | | | | | |
| 34 | Fe-24 Co-55 Si-6 B-15 | 66.0 | 0.47 -0.84 | 1.45 -3.12 | 197 | 7.9 |
| | | | | | | |
| 35 | Fe-29 Co-27 Ni-27 Si-1 B-16 | 31.8 | 0.10 -0.19 | 0.26 -0.58 | 37 | 17.1 |
| 36 | Fe-27 Co-27 Ni-27 Si-3 B-16 | 32.2 | 0.16 -0.31 | 0.46 -1.02 | 65 | 23.7 |

Die Nr. 28-33 haben einen gegenüber dem Stand der Technik (Nr. 3) deutlich reduzierten Co-Gehalt, weisen jedoch in der Regel eine Frequenzstreuung $\lvert df_r/dH_{bias} \rvert$ deutlich über 1 kHz auf. Nr. 34 weist zwar eine geringe Frequenzstreuung auf, was aber gegenüber dem Stand der Technik (Nr. 3) nur durch Erhöhung des Co-Gehaltes möglich war. Nachteilig sind demnach die erhöhten Legierungskosten.

Beispiel 35, 36 weisen gegenüber dem Stand der Technik (Nr. 3) einen geringeren Co-Gehalt und eine geringere Frequenzstreuung auf. Jedoch ist die Frequenzänderung nach Entmagnetisierung zu klein (< 1 kHz). Nachteilig ist ferner die kleine Signalamplitude.

Die Wärmebehandlung zur Einstellung einer flachen Schleife geschieht vorzugsweise bei einer Temperatur von 250 bis 450°C für eine Zeit von 2 bis 60 sec. Die kurze Behandlungszeit gestattet es, daß das Band im Durchlauf mit Hilfe eines Durchlaufofens vor dem Aufwickeln zu Spulen wärmebehandelt wird. Im Anschluß an die Wärmebehandlung im Durchlaufofen kann das austretende Band unmittelbar auf die gewünschte Länge für die Überwachungsstreifen abgelängt werden.

Typische Abmessungen des Streifens für den vorgesehenen Anwendungsfalls sind eine Länge von 30 bis 50 mm, eine Breite von 0,5 bis 25 mm und eine Dicke des amorphen Bandes im Bereich von 15 bis 40 µm. Die Abklingzeit sollte höher sein als 3 msec und das Vormagnetisierungsfeld liegt typischerweise im Bereich von 400 bis 800 A/m. Vorteilhafte Resonanzfrequenzen liegen im Bereich von 50 bis 60 kHz.

Ferner wurden Legierungszusammensetzungen entwickelt die den gängigen Bandbreiten von 6 mm bzw. 12.7 mm optimal angepaßt sind. Dies ist der Fall, wenn die Legierungszusammensetzung wie folgt lautet:

$$Fe_a Co_b Ni_c Si_x B_y M_z \text{ (at\%)},$$

mit a+b+c+x+y+z = 100, wobei

1. der Co-Gehalt bei b ≈ 7 - 20 at%
2. der Ni-Gehalt bei c ≈ 28 - 38 at%, vorzugsweise bei c ≈ 30 - 36 at%,
3. der Si-Gehalt im Bereich x ≈ 0 - 5 at%, vorzugsweise bei x ≈ 0 -2 at%,
4. der B-Gehalt im Bereich y ≈ 13 - 18 at%, vorzugsweise bei y ≈ 14 - 17 at% liegt,
5. M für eines oder mehrere der Elemente C, Mo, Nb, Ta, P oder anderer Elemente der Hauptgruppen IIIB-VIB bzw. IIIA-VA steht, deren Konzentration insgesamt bei x ≈ 0 - 3 at%, vorzugsweise bei x ≈ ≤ 1 at% liegt, und
6. die in at% angegebenen Konzentrationen von Co, Si, B und M die Beziehung

$$- 0.463 \, b_{Co} + 1.86 \, X_{si} + (y_B + z_M) \approx S,$$

erfüllen müssen, wobei S Werte zwischen S ≈ 8 und S ≈ 14 annehmen darf.

Der angegebene Bereich grenzt zunächst nur die generell in Frage kommenden Legierungen unabhängig von der speziellen Bandgeometrie ab. Er läßt sich weiter einengen, wenn man Bandbreite und Banddicke genauer spezifiziert.

Danach lassen sich, in Abhängigkeit der Bandgeometrie, für einen etwa 35 - 42 mm langen und etwa 20 - 30 μm dicken Streifen, die in Tabelle 4 angegebenen Werte für S und den Co-Gehalt eingrenzen.

**Tabelle 4:**

Bevorzugte Werte des Legierungsparameters S (s.Gl. unter Pkt.6) und des Co-Gehaltes bei denen mit 20 - 30 μm dicken, ca. 35 -42 mm Bandstreifen in der angegebenen Breite bei kurzzeitiger Wärmebehandlung im Querfeld eine Frequenzsteigung von ca. 600 Hz/Oe bei einem vormagnetisierenden Feld von 6 Oe erreicht wird.

| Bandbreite in mm | S | Co-Gehalt (at%) |
|---|---|---|
| 0,5 bis 15 | 8 bis 14 | 7 bis 20 |
| 1 bis 3 | 8.8 bis 10.5 | 13 bis 19 |
| 3 bis 5 | 9.5 bis 11.5 | 12 bis 18 |
| 5 bis 7 | 10.2 bis 12 | 10 bis 16 |
| 7 bis 10 | 10.8 bis 12.8 | 9 bis 15 |
| 10 bis 14 | 11.2 bis 13.5 | 8 bis 14 |

Sämtliche Materialien, die in den Ausführungsbeispielen und in der Beschreibung genannt und beschrieben sind, wurden über Stranggießen mit Rascherstarrung hergestellt. Verfahren und Vorrichtung sind seit langem bekannt und beispielsweise in der DE 37 31 781 C1 beschrieben.

**Patentansprüche**

1. Amorpher, duktiler, ferromagnetischer Streifen für ein Anzeigeelement in einem magnetischen Diebstahlsicherungssystem,

   • welcher durch Anlegen/Entfernen eines Vormagnetisierungsfeldes $H_{bias}$ aktivierbar/deaktivierbar ist und durch ein magnetisches Wechselfeld im aktivierten Zustand zu longitudinalen, mechanischen Resonanzschwingungen bei einer Resonanzfrequenz $f_r$ anregbar ist, wobei die aus den Resonanzschwingungen resultierenden mechanischen Spannungen eine Magnetisierungsänderung des Streifens und damit eine detektierbare Veränderung der Magnetisierung des Streifens bewirken, und

   • welcher eine magnetische Anisotropie quer zur Streifenlängsrichtung aufweist, wobei die Anisotropiefeldstärke $H_K$ größer als die Vormagnetisierungsfeldstärke $H_{bias}$ ist, und

   • welcher im aktivierten Zustand bei leichter Variation einer Testvormagnetisierungsfeldstärke $H_{bias}$ = 6 Oe eine Änderung der Resonanzfrequenz $df_r$ gegenüber der Änderung der Vormagnetisierungsfeldstärke $dH_{bias}$ von 400 Hz/Oe < $|df_r/dH_{bias}|$ < 800 Hz/Oe erfährt und beim Übergang vom aktivierten Zustand in den deaktivierten Zustand eine Änderung der Resonanzfrequenz $\Delta f_r$ > 1,2 kHz erfährt,

   wobei das amorphe; ferromagnetische Material eine flache B-H-Schleife aufweist, die bis in den Bereich der Sättigung möglichst linear verläuft, und eine Zusammensetzung hat, welche aus der Formel

   $$Fe_a Co_b Ni_c Si_d B_e\, C_f M_g$$

   besteht, wobei M zumindest eines der Elementegruppen $III_A$ bis $V_A$ und/oder $III_B$ bis $V_B$ des Periodensystems ist, a bis f in Atomprozent angegeben sind und folgenden Bedingungen genügen:

| | |
|---|---|
| $7 \leq b \leq 23$ | $10 \leq e \leq 20$ |
| $5 \leq c \leq 50$ | $0 \leq f \leq 2$ |

(fortgesetzt)

| 0 ≤ d ≤10 | 0 ≤ g ≤3 |
|-----------|----------|

mit b + c > 14; 12≤d + e + f + g ≤ 21 und
a + b + c + d + e + f + g = 100
**dadurch gekennzeichnet,**
**daß** der Streifen im abgelängten Zustand oder im bandförmigen nichtabgelängten Zustand in einem geeigneten Magnetfeld quer zur Bandrichtung einer Wärmebehandlung für eine Wärmebehandlungszeit 2 Sekunden ≤ t ≤ 60 Sekunden bei einer Temperatur 250° C ≤ T ≤ 450° C unterzogen wurde.

2. Streifen nach Anspruch 1,
   **dadurch gekennzeichnet,**
   **daß** die Wärmebehandlung im Durchlauf erfolgte und daß die Durchlaufgeschwindigkeit so gewählt wurde, daß das Band für eine Wärmebehandlungszeit 3 Sekunden ≤ t ≤ 10 Sekunden auf eine Temperatur 350° C ≤ T ≤ 400° C in einem Querfeld mit einer Feldstärke B ≥ 800 Oe erwärmt worden ist.

3. Streifen nach Anspruch 1 oder 2,
   **dadurch gekennzeichnet,**
   **daß** der Streifen eine Resonanzfrequenz $f_r$ von 50 kHz ≤ $f_r$ ≤ 60 kHz aufweist.

4. Streifen nach einem der Ansprüche 1 bis 3,
   **dadurch gekennzeichnet,**
   **daß** der Streifen nach erfolgter Resonanzanregung eine Abklingzeit $\tau_R$ ≥ 3 msek aufweist.

5. Streifen nach einem der Ansprüche 1 bis 4,
   **dadurch gekennzeichnet,**
   **daß** das amorphe, ferromagnetische Material eine Sättigungs-Magnetostriktion $\lambda_S$ ≥ 15 ppm aufweist.

6. Streifen nach einem der Ansprüche 1 bis 5
   **gekennzeichnet durch**
   folgende Bedingungen:

| | 0 ≤ d ≤ 5 |
|------------|-------------|
| 7 ≤ b ≤ 20 | 13 ≤ e ≤ 18 |
| 28 ≤ c ≤ 38 | 0 ≤ f ≤ 1. |

7. Streifen nach einem der Ansprüche 1 bis 6
   **gekennzeichnet durch**
   die Maßgabe 8 ≤ [ -0,463 b + 1,86 (d + g + (e+f)] ≤ 14.

8. Streifen nach einem der Ansprüche 1 bis 7
   **gekennzeichnet durch**
   die Bedingungen

| 30 ≤ c ≤ 36 | 14 ≤ e ≤ 17 |
|-------------|-------------|
| 0 ≤ d ≤ 2 | 0 ≤ f + g ≤ 1 |

9. Streifen nach einem der Ansprüche 1 bis 8
   **dadurch gekennzeichnet,**
   **daß** der Streifen eine Länge zwischen 25 mm und 50 mm, eine Breite zwischen 1 mm und 15 mm und eine Dicke zwischen 15 μm und 30 μm hat.

10. Streifen nach Anspruch 9
    **dadurch gekennzeichnet,**
    **daß** der Streifen eine Breite von ca. 4 mm aufweist und aus $Fe_{37,3} Co_{13} Ni_{34} Si_1 B_{14,3} C_{0,4}$ oder $Fe_{35,3} Co_{14,4} Ni_{34} Si_1 B_{14,9} C_{0,4}$ besteht.

**11.** Streifen nach Anspruch 9
**dadurch gekennzeichnet,**
**daß** der Streifen eine Breite von ca. 6 mm aufweist und aus $Fe_{37,5} Co_{15,3} Ni_{30} Si_{1,3} B_{15,5} C_{0,4}$ oder $Fe_{36,7} Co_{13} Ni_{34} Si_1 B_{14,9} C_{0,4}$ besteht.

**12.** Streifen nach Anspruch 9
**dadurch gekennzeichnet,**
**daß** der Streifen eine Breite von ca. 12 - 13 mm aufweist und aus $Fe_{39,9} Co_{12,8} Ni_{30} Si_{1,5} B_{15,5} C_{0,3};$ $Fe_{35,6} Co_{13} Ni_{34} Si_1 B_{16} C_{0,4};$ oder $Fe_{39,8-43,8} Co_{10} Ni_{30-34} Si_1 B_{14,8} C_{0,4}$ besteht.

## Claims

**1.** Amorphous ductile ferromagnetic strip for an indicating element in a magnetic theft-prevention system

- which strip can be activated/deactivated by applying/removing a premagnetizing field $H_{bias}$ and which can be excited in the activated state by an alternating magnetic field to undergo longitudinal mechanical resonant oscillations at a resonant frequency $f_r$, the mechanical stresses resulting from the resonant oscillations bringing about a magnetization change in the strip, and thus a detectable change in the magnetization of the strip,
- which strip has a magnetic anisotropy transverse with respect to the longitudinal direction of the strip, the anisotropic field strength $H_K$ being greater than the premagnetizing field strength $H_{bias}$, and
- which strip in the activated state experiences a change in the resonant frequency $df_r$ with respect to the change in the premagnetizing field strength $dH_{bias}$ of 400 Hz/Oe < $|df_r/dH_{bias}|$ < 800 Hz/Oe when there is a slight variation in a test premagnetizing field strength $H_{bias}$ = 6 Oe, and during the transition from the activated state to the deactivated state experiences a change in resonant frequency $\Delta f_r$ > 1.2 kHz,
- the amorphous ferromagnetic material, having a flat B-H loop which runs as far as possible linearly into the saturation region, and having a composition which is composed of the formula

$$Fe_a Co_b Ni_c Si_d B_e C_f M_g,$$

M being at least one of the element groups $III_A$ to $V_A$ and/or $III_B$ to $V_B$ of the periodic system, a to f being specified in atom % and satisfying the following conditions:

| | |
|---|---|
| $7 \le b \le 23$ | $10 \le e \le 20$ |
| $5 \le c \le 50$ | $0 \le f \le 2$ |
| $0 \le d \le 10$ | $0 \le g \le 3$ |

where b + c > 14; $12 \le d + e + f + g \le 21$ and a + b + c + d + e + f + g = 100,
**characterized in that** in the cut-to-length state or in the band-from, not cut-to-length, state, the strip was subjected to a thermal treatment in a suitable magnetic field transversely to the direction of the band for a thermal treatment time of 2 seconds $\le$ t $\le$ 60 seconds at a temperature of $250°C \le T \le 450°C$.

**2.** Strip according to Claim 1, **characterized in that** the thermal treatment was carried out in a continous operation, and **in that** the speed of the continuous process was selected such that the band is heated to a temperature of $350°C \le T \le 400°C$ in a cross field with a field strength B $\ge$ 800 Oe for a thermal treatment time of 3 seconds $\le$ t $\le$ 10 seconds.

**3.** Strip according to Claims 1 or 2, **characterized in that** the strip has a resonant frequency $f_r$ of 50 kHz $\le f_r \le$ 60 kHz

**4.** Strip according to one of Claims 1 to 3, **characterized in that** after resonant excitation has taken place the strip has a decay time of $\tau_R \ge$ 3 msec.

**5.** Strip according to one of Claims 1 to 4, **characterized in that** the amorphous ferromagnetic material has a saturation magnetostriction $\lambda_s \ge$ 15 ppm.

**6.** Strip according to one of Claims 1 to 5, **characterized by** the following conditions:

| | |
|---|---|
| | $0 \leq d \leq 5$ |
| $7 \leq b \leq 20$ | $13 \leq e \leq 18$ |
| $28 \leq c \leq 38$ | $0 \leq f \leq 1.$ |

**7.** Strip according to one of Claims 1 to 6, **characterized by** the condition $8 \leq [ -0.463 \, b + 1.86 \, (d + g + (e+f)] \leq 14$.

**8.** Strip according to one of Claims 1 to 7, **characterized by** the conditions

| | |
|---|---|
| $30 \leq c \leq 36$ | $14 \leq e \leq 17$ |
| $0 \leq d \leq 2$ | $0 \leq f + g \leq 1.$ |

**9.** Strip according to one of Claims 1 to 8, **characterized in that** the strip is between 25 mm and 50 mm long, between 1 mm and 15 mm wide and between 15 $\mu$m and 30 $\mu$m thick.

**10.** Strip according to Claim 9, **characterized in that** the strip is approximately 4 mm wide and is composed of $Fe_{37.3} Co_{13} Ni_{34} Si_1 B_{14.3} C_{0.4}$ or $Fe_{35.3} Co_{14.4} Ni_{34} Si_1 B_{14.9} C_{0.4}$.

**11.** Strip according to Claim 9, **characterized in that** the strip is approximately 6 mm wide and is composed of $Fe_{37.5} Co_{15.3} Ni_{30} Si_{1.3} B_{15.5} C_{0.4}$ or $Fe_{36.7} Co_{13} Ni_{34} Si_1 B_{14.9} C_{0.4}$.

**12.** Strip according to Claim 9, **characterized in that** the strip is approximately 12-13 mm wide and is composed of $Fe_{39.9} Co_{12.8} Ni_{30} Si_{1.5} B_{15.5} C_{0.3}$, $Fe_{35.6} Co_{13} Ni_{34} Si_1 B_{16} C_{0.4}$ or $Fe_{39.8-43.8} Co_{10} Ni_{30-34} Si_1 B_{14.8} C_{0.4}$.

**Revendications**

**1.** Bande ferromagnétique ductile, amorphe, pour un élément d'affichage dans un système anti-vol magnétique,

- qui est apte à être activée/désactivée par application/éloignement d'un champ de prémagnétisation $H_{bias}$ et peut être excitée par un champ magnétique alternatif à l'état activé pour donner des oscillations de résonance mécaniques, longitudinales, à une fréquence de résonance $F_r$, tandis que les tensions mécaniques résultant des oscillations de résonance ont pour effet une modification de la magnétisation de la bande et induisent ainsi une variation détectable de la magnétisation de la bande, et
- qui présente une anisotropie magnétique transversalement à la direction longitudinale de la bande, tandis que l'intensité du champ d'anisotropie $H_k$ est supérieure à l'intensité du champ de prémagnétisation $H_{bias}$, et
- qui subit, à l'état activé, pour une légère variation d'une intensité de champ de prémagnétisation d'essai $H_{bias}$ = 6 Oe, une modification de la fréquence de résonance $df_r$ par rapport à la modification de l'intensité du champ de prémagnétisation $dH_{bias}$ de 400 Hz/Oe < $|df_r/dH_{bias}|$ < 800 Hz/Oe et lors du passage de l'état activé à l'état désactivé subit une modification de la fréquence de résonance $\Delta f_r$ > 1,2 kHz,

tandis que le matériau ferromagnétique amorphe présente une boucle d'aimantation plate qui se développe le plus possible linéairement jusque dans le domaine de la saturation, et a une composition consistant en la formule

$$Fe_a Co_b Ni_c Si_d B_e C_f M_g$$

tandis que M est au moins l'un des groupes d'éléments $III_A$ à $V_A$ et/ou $III_B$ à $V_B$ de la classification périodique des éléments, a à f sont indiqués en pour cent d'atomes et satisfont aux conditions suivantes:

| | |
|---|---|
| $7 \leq b \leq 23$ | $10 \leq e \leq 20$ |
| $5 \leq c \leq 50$ | $0 \leq f \leq 2$ |
| $0 \leq d \leq 10$ | $0 \leq g \leq 3$ |

avec b + c > 14; $12 \leq d + e + f + g \leq 21$
et a + b + c + d + e + f + g = 100,

**caractérisée par le fait que** la bande dans l'état allongé ou dans l'état non allongé en forme de bande a été soumise à une température de 250°C ≤ T ≤ 450°C dans un champ magnétique approprié, transversalement à la direction de la bande, à un traitement thermique pour une durée de traitement thermique de 2 secondes ≤ t ≤ 60 secondes.

2. Bande selon la revendication 1,
   **caractérisée par le fait que** le traitement thermique a été accompli en une passe et que la vitesse de passage a été choisie de telle manière que la bande a été chauffée pendant une durée de traitement thermique de 3 secondes ≤ t ≤ 10 secondes à une température de 350°C ≤ T ≤ 400°C dans un champ transversal ayant une intensité de champ B ≥ 800 Oe.

3. Bande selon la revendication 1 ou 2,
   **caractérisée par le fait que** la bande présente une fréquence de résonance $f_r$ de 50 kHz ≤ $f_r$ ≤ 60 kHz.

4. Bande selon l'une des revendications 1 à 3,
   **caractérisée par le fait que** la bande présente après réalisation d'une excitation par résonance une durée d'évanouissement $\tau_R$ ≥ 3 ms.

5. Bande selon l'une des revendications 1 à 4,
   **caractérisée par le fait que** le matériau ferromagnétique amorphe présente une magnétostriction de saturation $\lambda_S$ ≥ 15 ppm.

6. Bande selon l'une des revendications 1 à 5,
   **caractérisée par** les conditions suivantes:

|  | 0 ≤ d ≤ 5 |
|---|---|
| 7 ≤ b ≤ 20 | 13 ≤ e ≤ 18 |
| 28 ≤ c ≤ 38 | 0 ≤ f ≤ 1. |

7. Bande selon l'une des revendications 1 à 6, **caractérisée par** la condition 8 ≤ [-0,463 b + 1,86 (d + g + (e + f)] ≤ 14.

8. Bande selon l'une des revendications 1 à 7,
   **caractérisée par** les conditions:

| 30 ≤ c ≤ 36 | 14 ≤ e ≤ 17 |
|---|---|
| 0 ≤ d ≤ 2 | 0 ≤ f + g ≤ 1. |

9. Bande selon l'une des revendications 1 à 8,
   **caractérisée par le fait que** la bande a une longueur entre 25 mm et 50 mm, une largeur entre 1 mm et 15 mm et une épaisseur entre 15 µm et 30 µm.

10. Bande selon la revendication 9,
    **caractérisée par le fait que** la bande présente une largeur d'environ 4 mm et consiste en $Fe_{37,3} Co_{13} Ni_{34} Si_1 B_{14,4} C_{0,4}$ ou $Fe_{35,3} Co_{14,4} Ni_{34} Si_1 B_{14,9} C_{0,4}$.

11. Bande selon la revendication 9,
    **caractérisée par le fait que** la bande présente une largeur d'environ 6 mm et consiste en $Fe_{37,5} Co_{15,3} Ni_{30} Si_{1,3} B_{15,5} C_{0,4}$ ou $Fe_{36,7} Co_{13} Ni_{34} Si_1 B_{14,9} C_{0,4}$.

12. Bande selon la revendication 9,
    **caractérisée par le fait que** la bande présente une largeur d'environ 12 - 13 mm et consiste en $Fe_{39,9} Co_{12,8} Ni_{30} Si_{1,5} B_{15,5} C_{0,3}$; $Fe_{35,6} Co_{13} Ni_{34} Si_1 B_{16} C_{0,4}$; ou $Fe_{39,8-43,8} Co_{10} Ni_{30-34} Si_1 B_{14,6} C_{0,4}$.

201-1757/306-9, VC 7250 M50, 7s 360°C (T 1267), Probe 1, (6 mm, 24.6 μm)

$H_{bias}$ = 6.5 Oe

kontinuierliche Anregung
Pulsanregung

Induzierte Spannungsamplitude (mV)

Frequenz (kHz)

Fig. 1

$A$ (mV), $H_{ac}$ (mOe)

$A$

$H_{ac}$

Zeit (ms)

Fig. 2

201-1757/306-9, VC 7250 M50, 7s 360°C (T 1267), Probe 1, (6 mm, 24.6 μm)

201-1757/306-9, VC 7250 M50, 7s 360°C (T 1267), Probe 1, (6 mm, 24.6 μm)

Fig. 3

**Fig. 4**

**Fig. 5**

**Fig. 6**

**Fig. 7**

**(a)**

VC 7250, 201-1681, 8.5s bei Ta (38mm x 6mm x 25 µm)

**(b)**

VC 7250, 201-1681, Ta =360°C (38mm x 6mm x 25 µm)

**Fig. 8**

Fig. 9